# EUROPÄISCHE PATENTSCHRIFT

(11) **EP 0 830 324 B1**
(45) Veröffentlichungstag und Bekanntmachung des Hinweises auf die Patenterteilung: **21.04.1999**
(21) Anmeldenummer: 96900850.7
(22) Anmeldetag: 17.01.1996
(51) Int. Cl.: C03C 29/00, H01L 21/316, C04B 37/00, C03B 8/02

(54) **VERFAHREN ZUR HERSTELLUNG VON GLASSCHICHTEN ZUM ZWECKE DES ANODISCHEN BONDENS**
PROCESS FOR PRODUCING GLASS COATINGS FOR ANODIC BONDING PURPOSES
PROCEDE DE PRODUCTION DE COUCHES DE VERRE POUR LIAISON ANODIQUE

(30) Priorität: 20.01.1995 DE 19501712
(43) Veröffentlichungstag der Anmeldung: 25.03.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: QUENZER, Hans-Joachim, D-12207 Berlin (DE); DELL, Carola, D-10781 Berlin (DE)
(74) Vertreter: Pfenning, Meinig & Partner
(86) Internationale Anmeldenummer: DE9600103
(87) Internationale Veröffentlichungsnummer: WO9622256

(56) Entgegenhaltungen:
- EP-A- 0 424 638
- GB-A- 2 165 234
- DATABASE WPI Section Ch, Week 9401 Derwent Publications Ltd., London, GB; Class E11, AN 94-003416 XP002001208 & JP,A,05 315 319 (SHOKUBAI KASEI KOGYO KK) , 26.November 1993
- PATENT ABSTRACTS OF JAPAN vol. 016, no. 158 (E-1191), 17.April 1992 & JP,A,04 010418 (CATALYSTS & CHEM IND CO LTD), 14.Januar 1992,
- CHEMICAL ABSTRACTS, vol. 104, no. 24, 16.Juni 1986 Columbus, Ohio, US; abstract no. 211890u, Seite 283; XP002001207 & JP,A,61 026 524 (SUWA SEIKOSHI CO.,LTD.) 5.Februar 1986

## Beschreibung

Die Erfindung bezieht sich auf ein Verfahren, um Verbindungen zwischen einem alkalihaltigen Glas und einem elektrisch leitenden Material, beispielsweise einem Metall oder einem Halbleiter, herzustellen. Derartige Verbindungen eignen sich insbesondere, um zwei Halbleiterelemente, beispielsweise zwei Siliziumwafer, flächig mit einer dazwischenliegenden alkalihaltigen Glasschicht zu verbinden. Diese Verfahren werden vor allem in der Halbleiterindustrie eingesetzt.

Unter dem anodischen Bonden versteht man ein Verfahren, um eine Verbindung zwischen alkalihaltigem Glas und elektrisch leitendem Material herzustellen. Das anodische Bonden eignet sich insbesondere zur Verbindung eines Halbleiterplättchens mit einer Glasschicht. Dabei wird bei einer Temperatur von 300° C bis 450° C zwischen dem ionenleitenden alkalihaltigen Glas und dem Halbleiter, beispielsweise Silizium, eine elektrische Spannung angelegt. Diese elektrische Spannung verursacht an der Grenzschicht zwischen Glas und Halbleiter elektrochemische Reaktionen, durch die das Glas mit dem Halbleiter fest verbunden wird. Entscheidend für das anodische Bonden ist im wesentlichen der Alkaligehalt der Glasschicht. Im Ergebnis ergibt sich eine feste unlösbare Verbindung zwischen dem alkalihaltigen Glas und dem Halbleitermaterial.

Für das anodische Bonden von Siliziumwafern sind insbesondere Borosilikatgläser mit variablem Gehalt an B₂O₃, SiO₂ und/oder Al₂O₃ geeignet. Sie zeichnen sich durch ihre große chemische Beständigkeit und durch einen geringen Ausdehnungskoeffizienten aus.

Die zum anodischen Bonden nötigen Glasschichten werden üblicherweise mit molekularen Beschichtungsverfahren, wie etwa Sputtern oder Aufdampfen oder durch Beschichtung mit entsprechenden Sollösungen hergestellt. Bei den molekularen Beschichtungsverfahren ergeben sich jedoch bei größeren Schichtdicken, wie sie beispielsweise zur Verbindung zweier Siliziumwafer benötigt werden, Prozeßzeiten von einigen Stunden. Darüber hinaus ist die Herstellung solcher Schichten in Sputter- oder Aufdampfanlagen immer mit der Ausbildung ebensolcher dicker. Beläge innerhalb der Geräte verbunden. Diese Beläge müssen von Zeit zu Zeit entfernt werden, was zu häufigen Wartungs- und Reinigungsarbeiten führt. Daher ist der Auftrag von Glasschichten durch molekulare Beschichtungsverfahren wie Sputtern oder Aufdampfen für das anodische Bonden mit Glaszwischenschichten teuer und unrentabel.

Demgegenüber zeichnen sich Glasbeschichtungen, die durch Aufschleudern oder Tauchen von entsprechenden Sollösungen hergestellt wurden, dadurch aus, daß das Beschichtungsverfahren und die dazu nötigen Geräte preiswert sind. Üblicherweise werden hierfür Sol-Gel-Beschichtungen auf der Basis von TEOS (Tetraethylorthosilikat) verwendet. Bei Verwendung dieses Beschichtungsverfahrens treten allerdings bei den nötigen Schichtdicken für das anodische Bonden zweier Halbleiterplatten innerhalb der Schichten mechanische Spannungen auf, die zur Ausbildung von Rissen führen. Daher können die üblicherweise verwendeten Sol-Gel-Beschichtungen auf der Basis von TEOS für die Herstellung von Schichtdicken, die 100 nm überschreiten, nicht verwendet werden.

Zusammenfassend läßt sich feststellen, daß zur Herstellung von Glasschichten zum anodischen Bonden mit einer Dicke zwischen 0,1 und 10 µm, wie sie beispielsweise für das anodische Bonden zweier Halbleiterplatten benötigt werden, die molekularen Auftragungsverfahren wie Sputtern oder Aufdampfen sehr teuer und mit großem Wartungs- und Reinigungsaufwand verbunden sind, während die preiswerten Verfahren, bei denen geeignete Sollösungen beispielsweise durch Aufschleudern oder Tauchen aufgetragen werden, sich nicht zur Herstellung derartig dicker Glasschichten eignen. Es steht also bisher kein geeignetes und gleichzeitig kostengünstiges Verfahren zur Herstellung von alkalihaltigen Glasschichten mit einer Dicke zwischen etwa 0,1 und etwa 10 µm zur Verfügung.

Aufgabe der Erfindung ist es daher, ein einfaches und kostengünstiges Verfahren zum anodischen Bonden zur Verfügung zu stellen, bei dem alkalihaltige Glasschichten mit einer Dicke, die 100 nm überschreitet und auch bis zu etwa 10 µm erreichen kann, auf einem elektrisch leitenden Trägermaterial, wie beispielsweise Halbleiterwafern aus Silizium, verwendet werden. Weiterhin ist es Aufgabe der Erfindung, geeignete Sollösungen vorzuschlagen, die zur Erzeugung derartiger Glasschichten mit dem erfindungsgemäßen Verfahren verwendet werden können.

Diese Aufgabe wird durch das erfindungsgemäße Verfahren nach dem Oberbegriff in Verbindung mit den kennzeichnenden Merkmalen des Anspruchs 1 gelöst.

Für das erfindungsgemäße Verfahren zum anodischen Bonden wird die erfindungsgemäße Glasschicht auf dem elektrisch leitenden Material erzeugt, indem zuerst ein SiO₂-Sol in wenigstens einem oder auch in einer Mischung aus mehreren n-Alkanolen hergestellt wird, wobei n einen Wert zwischen 1 und 5 besitzt. Diesem Organosol wird Tetraethylorthosilikat und/oder Methyltriethoxysilan zugesetzt. Weiterhin wird eine kleine Menge Säure sowie anschließend Wasser und die gewünschte Menge Alkalisalze zugegeben, wobei sowohl die Säure als auch die Alkalisalze in einem n-Alkanol mit n = 1 bis 5 gelöst sein können. Daraufhin wird diese Lösung über längere Zeit polymerisiert. Es wird eine fast klare, opaleszierende Lösung erhalten, die sehr gut zum Beschichten geeignet ist. Bei dieser Lösung können insbesondere auch hohe Anteile an Alkalisalzen bis in den Prozentbereich zugesetzt werden, ohne daß die Lösung ausfällt. Diese erfindungsgemäße Sollösung besitzt eine große Standzeit und kann über viele Stunden hinweg aufbewahrt und anschließend ohne Qualitätsverlust weiterverarbeitet werden. Sie wird auf das zu beschichtende elektrisch leitende Material in ansonsten bekannter Weise, beispielsweise durch Tauchen, Aufschleudern oder Sprühen aufgetragen. Die Beschichtung wird getrocknet und bei einer Temperatur ausgeheizt (getempert), die je nach den gewünschten Eigenschaften der Glasschicht gewählt werden kann. Wird dieses Verfahren einmal durchgeführt, so lassen sich Schichtstärken von 1 bis 2 µm erreichen. Um größere Schichtdicken, wie beispielsweise 2 bis 10 µm, zu erreichen, kann dieses Verfahren mehrfach wiederholt werden, wobei zwischen den einzelnen Beschichtungsschritten jeweils die neu aufgetragene Schicht getrocknet und getempert werden muß.

Anschließend an die letzte Temperung der Glasschicht kann das elektrisch leitende Trägermaterial mit der so erzeugten Glasschicht mittels Anlegens eines elektrischen Stromes, der über die Grenzschicht zwischen elektrisch leitendem Material und der Glasschicht fließt, in ansonsten bekannter Weise verbunden (gebondet) werden.

Das erfindungsgemäße Verfahren eignet sich für das anodische Bonden der entsprechend dem erfindungsgemäßen Verfahren hergestellten Glasschicht mit jedem elektrisch leitenden Material, insbesondere Halbleitermaterialien wie beispielsweise Siliziumwafern.

Durch dieses erfindungsgemäße Verfahren steht nun ein einfaches und kostengünstiges Verfahren zur Verfügung, elektrisch leitende Trägermaterialien mit alkalihaltigen Glasschichten zu versehen und zu verbinden, die eine Dicke bis zu 10 µm erreichen können. Besonders vorteilhaft ist, daß zur Erzeugung der Glasschicht aus einem Sol hierzu die relativ einfachen und kostengünstigen Auftragungsverfahren wie Aufschleudern, Aufsprühen oder Tauchen verwendet werden können. Die erzeugte alkalihaltige Glasschicht ist weitgehend frei von Rissen und eignet sich sehr gut zum anodischen Bonden. Insbesondere lassen sich zwei Schichten elektrisch leitenden Materials, wie beispielsweise zwei Siliziumwafer, durch eine erfindungsgemäß hergestellte Glasschicht fest und unlösbar miteinander verbinden.

Vorteilhaft an dem erfindungsgemäßen Verfahren ist außerdem, daß die Konzentration der Alkaliionen in der fertigen Glasschicht durch den Zuschlag unterschiedlicher Mengen an Alkalisalzen zu der erfindungsgemäßen Sollösung in weiten Bereichen eingestellt werden kann.

Vorteilhafte Weiterbildungen des erfindungsgemäßen Verfahrens und der erfindungsgemäßen Sol-Lösungen sind in den abhängigen Ansprüchen geschildert.

Es hat sich als vorteilhaft erwiesen, als Alkalisalze Natriumverbindungen zu verwenden, die vorteilhafterweise in einem n-Alkanol mit n = 1 bis 5, beispielsweise in Ethanol und/oder Methanol, gelöst werden können. Als zuzugebende Säure erwies sich Essigsäure als besonders geeignet. Auch diese wird vorteilhafterweise vor Zugabe zu der Sollösung in einem n-Alkanol mit n = 1 bis 5, beispielsweise in Ethanol, gelöst.

Über die Konzentration der Sollösung läßt sich die Dicke der fertigen Glasschicht regulieren. Sofern mit einem Beschichtungsschritt eine dünnere Glasschicht erzeugt werden soll, kann die Sollösung vor der Beschichtung mit n-Alkanolen, wobei n zwischen 1 und 5 liegt, verdünnt werden. Gleichermaßen kann die Sollösung eingeengt werden, wodurch sich die Schichtdicke der Einzelbeschichtung erhöht. Vorteilhafterweise wird zur Verdünnung dasjenige n-Alkanol verwendet, das Lösungsmittel der Sollösung ist.

Die Eigenschaften der fertigen Glasschicht werden sehr stark durch die Temperatur beeinflußt, bei der die aufgetragene und getrocknete Sollösung getempert wird. Wird bei einer Temperatur unterhalb 400° C getempert, so verbleibt in dem fertigen Glas ein großer Anteil organischen Materials, beispielsweise in Form von Methylgruppen. Es handelt sich folglich bei dem fertigen Glas um organisch modifizierte Silikate mit zusätzlichen Alkaliionen.

Wird die Glasschicht bei Temperaturen oberhalb 450° C beispielsweise an Luft oder Sauerstoff getempert, so wird die Glasschicht praktisch vollständig verdichtet.

Wird bei Temperaturen oberhalb 650° C getempert, so ergibt sich eine sehr dichte Glasschicht, die einen Na₂O-Gehalt besitzt, der durch Zugabe entsprechender Mengen Alkalisalze zu der Sol-Lösung sehr genau vorherbestimmt werden kann. Derartige dichte Glasschichten zeichnen sich durch sehr hohe Zugfestigkeit aus und sind selbst gegen alkalisches Ätzen resistent.

Unabhängig von der Temperatur, bei der die Glasschicht getempert wurde und unabhängig von der Anzahl und/oder Reihenfolge der Temperphasen sind sämtliche durch das erfindungsgemäße Verfahren hergestellte Glasschichten sehr gut bondbar.

Verbesserungen bzw. Änderungen der Eigenschaften der erfindungsgemäß hergestellten Glasschicht können durch Zugabe weiterer chemischer Verbindungen zu der erfindungsgemäßen Sollösung erreicht werden. Beispielsweise können zur Verbesserung der chemischen Beständigkeit und zur Anpassung des Ausdehnungskoeffizienten der Glasschicht an die zu bondenden Materialien Borverbindungen wie Borsäure und/oder organische Aluminiumverbindungen zugegeben werden, ohne daß die für das anodische Bonden funktionell wichtigen Eigenschaften der fertigen Glasschicht beeinträchtigt werden.

Im folgenden sollen einige besonders bevorzugte und besonders einfache beispielhafte Ausführungsformen der Erfindung dargestellt werden, ohne dadurch den Umfang der Erfindung auf diese beipielhafte Ausführungsformen einzuschränken.

### Beispiel 1

Ausgehend von einer wässrigen Lösung von Siliziumdioxid-Partikeln mit einem durchschnittlichen Durchmesser von 7 nm wurde ein ethanolisches Alkoholsol hergestellt. Zu 50 g dieses Alkoholsols, dessen pH-Wert bei 2 lag, wurden 35,6 g Methyltriethoxysilan und 11,5 g Tetraethylorthosilikat zugegeben. Anschließend wurden 10 g Wasser und 16 g 10 %ige Natriumacetatlösung in Methanol unter ständigem Rühren zugegeben. Anschließend wurde diese Mischung für 36 bis 38 Stunden auf 22° C temperiert.

Nach Abschluß der Reaktion erhält man eine fast klare, aber opaleszierende Lösung, die zum Beschichten durch Tauchen, Aufschleudern oder Sprühen geeignet ist. Nach der Beschichtung eines Siliziumträgermaterials mit dieser Lösung wurde die Schicht getrocknet und schließlich bei einer Temperatur unter 400° C getempert.

Es wurde eine Glasschicht erhalten, die einen relativ großen Anteil organischen Materials (Methylgruppen) enthielt. Diese erzeugte Schicht eignete sich sehr gut zum anodischen Bonden und ergab nach dem in herkömmlicher Weise erfolgten Bonden durch einen elektrischen Strom einen festen Verbund zwischen dem Siliziumträgermaterial und der Glasschicht.

### Beispiel 2

Es wurde eine Glasschicht wie in Beispiel 1 hergestellt und anschließend bei Temperaturen oberhalb von 450°C getempert. Dies führte zu einer weiteren Verdichtung der Glasschicht.

### Beispiel 3

Es wurde eine Glasschicht wie in Beispiel 2 hergestellt und anschließend oberhalb von 650° C getempert. Es entstand eine sehr dichte Glasschicht. Diese Schicht besaß eine besonders hohe Zugfestigkeit und erwies sich als resistent gegenüber alkalischem Ätzen mit 25 %iger Tetramethylammoniumhydroxid-Lösung. Derartige Tetramethylammoniumhydroxid-Lösungen finden insbesondere bei der Herstellung mikromechanischer Bauteile Verwendung. Die in diesem Beispiel hergestellte Glasschicht eignet sich daher insbesondere für die Verwendung bei der industriellen Fertigung derartiger Bauteile.

## Patentansprüche

1. Verfahren zum anodischen Bonden eines alkalihaltigen Glases mit einem elektrisch leitenden Material durch Aufbringen einer alkalihaltigen Glasschicht auf das elektrisch leitende Material und anschließendem Verbinden der Glasschicht mit dem elektrisch leitenden Material mittels eines elektrischen Stromes in ansonsten bekannter Weise,
**dadurch gekennzeichnet,**
daß zum Aufbringen der alkalihaltigen Glasschicht auf das elektrisch leitende Material ein SiO₂-Sol in einem oder in einer Mischung aus mehreren n-Alkanolen hergestellt wird, wobei n einen Wert zwischen 1 und 5 besitzt, diesem Organosol TEOS (Tetraethylorthosilikat) und/oder MTEOS (Methyltriethoxysilan) sowie eine kleine Menge Säure zugesetzt wird,
nach der Zugabe der Säure Wasser sowie Alkalisalze zugegeben werden und diese Lösung anschließend zumindest teilweise polymerisiert wird und
daß anschließend diese Lösung auf das elektrisch leitende Material in ansonsten bekannter Weise aufgetragen und die Beschichtung getrocknet und ausgeheizt wird.

2. Verfahren nach Anspruch 1, dadurch gekennzeichnet, daß als Alkalisalze Natriumverbindungen verwendet werden.

3. Verfahren nach einem der vorhergehenden Ansprüche, dadurch gekennzeichnet, daß die auf dem zu beschichtenden Teil aufzutragende Lösung eingeengt oder mit n-Alkanolen mit n zwischen 1 und 5, vorteilhafterweise Ethanol, verdünnt wird, um die Schichtdicke der Beschichtung zu verändern.

4. Verfahren nach einem der vorhergehenden Ansprüche, dadurch gekennzeichnet, daß als Säure Essigsäure verwendet wird.

5. Verfahren nach einem der vorhergehenden Ansprüche, dadurch gekennzeichnet, daß die Alkalisalze und/oder die Säure vor der Zugabe zu der Sollösung in einem oder in einer Mischung aus mehreren n-Alkanolen mit n zwischen 1 und 5, vorteilhafterweise in Ethanol, gelöst wird.

6. Verfahren nach einem der vorhergehenden Ansprüche, dadurch gekennzeichnet, daß die Beschichtung anschließend bei bis zu 400 °C getempert wird.

7. Verfahren nach einem der vorhergehenden Ansprüche, dadurch gekennzeichnet, daß die Beschichtung anschließend bei Temperaturen oberhalb von 450 °C an Luft oder Sauerstoff getempert wird.

8. Verfahren nach einem der vorhergehenden Ansprüche, dadurch gekennzeichnet, daß die Beschichtung anschließend bei Temperaturen oberhalb von 650 °C getempert wird.

9. Verfahren nach einem der vorhergehenden Ansprüche, dadurch gekennzeichnet, daß die Eigenschaften der durch das Verfahren erzeugten Glasschicht durch Zugabe weiterer chemischer Verbindungen, beispielsweise von Borverbindungen wie Borsäure oder von organischen Aluminiumverbindungen, gezielt verändert werden.

10. Sollösung zur Herstellung von Glasbeschichtungen für elektrisch leitende Materialien, die sich zum anodischen Bonden eignen,
**dadurch gekennzeichnet,** daß die Sollösung ein SiO₂-Organosol in mindestens einem oder einer Mischung aus mehreren n-Alkanolen enthält, wobei n werte zwischen 1 und 5 besitzt und wobei dieses Organosol weiterhin TEOS (Tetraethylorthosilikat) und/oder MTEOS (Methyltriethoxysilan) und eine kleine Menge Säure enthält, und daß diesem Organosol Wasser sowie Alkalisalze zugegeben wurden und das Organosol anschließend teilweise polymerisiert wurde.

11. Sollösung nach Anspruch 10, dadurch gekennzeichnet, daß als Alkalisalze Natriumverbindungen verwendet werden.

12. Sollösung nach Anspruch 10 oder 11, dadurch gekennzeichnet, daß die Alkalisalze und/oder die Säure in einem oder in einer Mischung von mehreren n-Alkanolen mit n zwischen 1 und 5, vorteilhafterweise Ethanol und/oder Methanol, gelöst zugegeben werden.

13. Sollösung nach mindestens einem der Ansprüche 10 bis 12, dadurch gekennzeichnet, daß als Säure Essigsäure verwendet wird.

14. Sollösung nach mindestens einem der Ansprüche 10 bis 13, dadurch gekennzeichnet, daß die Sollösung als weitere chemische Verbindungen Borverbindungen wie Borsäure oder organische Aluminiumverbindungen enthält.

15. Verwendung von Sollösungen gemäß mindestens einem der Ansprüche 10 bis 14 zum Erzeugen von dünnen alkalihaltigen Glasschichten auf elektrisch leitenden Materialien, die zum anodischen Bonden elektrisch leitender Schichten und/oder auch als Zwischenschicht zur Verbindung zweier elektrisch leitender Schichten geeignet sind.

## Claims

1. Process for the anodic bonding of an alkaline glass with an electrically conductive material by applying an alkaline glass coating onto the electrically conductive material and subsequently bonding the glass coating with the electrically conductive material by means of an electric current in an otherwise known manner, characterised in that for application of the alkaline glass coating onto the electrically conductive material, an SiO₂ sol is produced
in one n-alkanol or in a mixture of several n-alkanols, n thereby having a value of between 1 and 5, TEOS (tetraethyl orthosilicate) and/or MTEOS (methyl triethyoxysilane) as well as a small quantity of acid are added to this organosol,
after addition of the acid, water as well as alkaline salts are added and this solution is subsequently at least partially polymerised, and
that this solution is then applied onto the electrically conductive material in an otherwise known manner and the coating is dried and baked.

2. Process according to Claim 1, characterised in that sodium compounds are used as alkaline salts.

3. Process according to one of the preceding claims, characterised in that the solution to be applied onto the part to be coated is concentrated to low volume or diluted with n-alkanols with n between 1 and 5, preferably ethanol, in order to change the layer thickness of the coating.

4. Process according to one of the preceding claims, characterised in that acetic acid is used as acid.

5. Process according to one of the preceding claims, characterised in that the alkaline salts and/or acid is/are dissolved before adding to the sol solution in one n-alkanol or in a mixture of several n-alkanols with n between 1 and 5, preferably in ethanol.

6. Process according to one of the preceding claims, characterised in that the coating is subsequently tempered at up to 400°C.

7. Process according to one of the preceding claims, characterised in that the coating is subsequently tempered in air or oxygen at temperatures above 450°C.

8. Process according to one of the preceding claims, characterised in that the coating is subsequently tempered at temperatures above 650°C.

9. Process according to one of the preceding claims, characterised in that the properties of the glass coating generated by the process are purposefully changed by adding further chemical compounds, e.g. boron compounds such as boric acid, or organic aluminium compounds.

10. Sol solution for the production of glass coatings for electrically conductive materials suitable for anodic bonding, characterised in that the sol solution contains an SiO₂ organosol in at least one n-alkanol or in a mixture of several n-alkanols, n thereby having a value of between 1 and 5, whereby this organosol also contains TEOS (tetraethyl orthosilicate) and/or MTEOS (methyl triethyoxysilane) and a small quantity of acid, and that water as well as alkaline salts were added to this organosol and the organosol was subsequently partially polymerised.

11. Sol solution according to Claim 10, characterised in that sodium compounds are used as alkaline salts.

12. Sol solution according to Claim 10 or 11, characterised in that the alkaline salts and/or acid is/are added in solution in one n-alkanol or in a mixture of several n-alkanols with n between 1 and 5, preferably ethanol and/or methanol.

13. Sol solution according to at least one of Claims 10 to 12, characterised in that acetic acid is used as acid.

14. Sol solution according to at least one of Claims 10 to 13, characterised in that the sol solution contains boron compounds such as boric acid or organic aluminium compounds as further chemical compounds.

15. Use of sol solutions according to at least one of Claims 10 to 14 for the generation of thin alkaline glass coatings on electrically conductive materials suitable for the anodic bonding of electrically conductive layers and/or also suitable as intermediate layer for bonding two electrically conductive layers.

## Revendications

1. Procédé de liaison anodique d'un verre alcalin avec un matériau électriquement conducteur par application d'une couche de verre alcalin sur le matériau électriquement conducteur et liaison de la couche de verre avec le matériau électriquement conducteur au moyen d'un courant électrique d'une façon par ailleurs connue,
caractérisé en ce que, pour appliquer la couche de verre alcalin sur le matériau électriquement conducteur est produit un sol de SiO₂ dans un n-alcanol ou dans un mélange de plusieurs n-alcanols, où n est une valeur comprise entre 1 et 5, on ajoute à cet organosol du TEOS (orthosilicate de tétraéthyle) et/ou du MTEOS (triéthoxysilane de méthyle), ainsi qu'une faible quantité d'acide, puis, après ajout de l'acide, de l'eau et des sels alcalins, cette solution est ensuite au moins en partie polymérisée, et en ce qu'ensuite, cette solution est appliquée sur le matériau électriquement conducteur d'une façon par ailleurs connue, puis le revêtement est séché et chauffé.

2. Procédé selon la revendication 1, caractérisé en ce que l'on utilise des composés de sodium en tant que sels alcalins.

3. Procédé selon l'une des revendications précédentes, caractérisé en ce que la solution à appliquer sur la pièce à recouvrir est concentrée ou diluée avec des n-alcanols, n étant compris entre 1 et 5, de préférence avec de l'éthanol, pour modifier l'épaisseur de la couche de revêtement.

4. Procédé selon l'une des revendications précédentes, caractérisé en ce que l'on utilise de l'acide acétique en tant qu'acide.

5. Procédé selon l'une des revendications précédentes, caractérisé en ce que, avant l'ajout à la solution colloïdale, les sels alcalins et/ou l'acide sont dissous dans un n-alcanol ou dans un mélange de plusieurs n-alcanols, où n est compris entre 1 et 5, de préférence dans de l'éthanol.

6. Procédé selon l'une des revendications précédentes, caractérisé en ce que le revêtement est ensuite trempé à une température allant jusqu'à 400 °C.

7. Procédé selon l'une des revendications précédentes, caractérisé en ce que le revêtement est ensuite trempé à une température supérieure à 450 °C, à l'air ou à l'oxygène.

8. Procédé selon l'une des revendications précédentes, caractérisé en ce que le revêtement est ensuite trempé à une température supérieure à 650 °C.

9. Procédé selon l'une des revendications précédentes, caractérisé en ce que les propriétés de la couche de verre produite selon le procédé sont modifiées de façon appropriée par l'ajout d'autres composés chimiques, par exemple de composés de bore comme l'acide borique ou de composés organiques d'aluminium.

10. Solution colloïdale pour produire des revêtements de verre pour matériaux électriquement conducteurs, qui sont appropriés pour une liaison anodique,
caractérisée en ce que la solution colloïdale contient un organosol de SiO₂ dans au moins un n-éthanol ou dans un mélange de plusieurs n-éthanols, n étant une valeur comprise entre 1 et 5, cet organosol comprenant en outre du TEOS (orthosilicate de tétraéthyle) et/ou du MTEOS (triéthoxysilane de méthyle) et une faible quantité d'acide, et en ce qu'à cet organosol sont en outre ajoutés de l'eau et des sels alcalins, l'organosol étant ensuite en partie polymérisé.

11. Solution colloïdale selon la revendication 10, caractérisée en ce que l'on utilise des composés de sodium en tant que sels alcalins.

12. Solution selon la revendication 10 ou 11, caractérisée en ce que les sels alcalins et/ou l'acide sont ajoutés dissous dans un n-alcanol ou dans un mélange de plusieurs n-alcanols, n étant compris entre 1 et 5, de préférence dans de l'éthanol et/ou du méthanol.

13. Solution colloïdale selon au moins l'une des revendications 10 à 12, caractérisée en ce que l'on utilise de l'acide acétique en tant qu'acide.

14. Solution colloïdale selon au moins l'une des revendications 10 à 13, caractérisée en ce que la solution colloïdale contient en tant qu'autres composés chimiques des composés de bore comme de l'acide borique ou des composés organiques d'aluminium.

15. Utilisation de solutions colloïdales selon au moins l'une des revendications 10 à 14 pour produire de fines couches de verre alcalin sur des matériaux électriquement conducteurs, qui sont appropriées pour une liaison anodique de couches électriquement conductrices et/ou en tant que couches intermédiaires pour une liaison de deux couches électriquement conductrices.
